# FASCICULE DE BREVET EUROPEEN

(11) **EP 0 351 316 B1**
(45) Date de publication et mention de la délivrance du brevet: **15.06.1994**
(21) Numéro de dépôt: 89402006.4
(22) Date de dépôt: 12.07.1989
(51) Int. Cl.: H01L 21/82, H01L 21/28, H01L 29/788

(54) **Procédé de fabrication d'une cellule de mémoire intégrée**
Verfahren zur Herstellung einer integrierten Speicher-Zelle
Process for manufacturing an integrated memory-cell

(30) Priorité: 13.07.1988 FR 8809559
(43) Date de publication de la demande: 17.01.1990
(73) Titulaire: COMMISSARIAT A L'ENERGIE ATOMIQUE, 75015 Paris Cédex 15 (FR)
(72) Inventeur: Jeuch, Pierre, F-38170 Seyssins (FR)
(74) Mandataire: Dubois-Chabert, Guy

(56) Documents cités:
- EP-A- 0 088 922
- EP-A- 0 160 965
- EP-A- 0 258 141
- US-A- 4 402 128
- US-A- 4 597 060
- US-A- 4 749 443
- PATENT ABSTRACTS OF JAPAN, vol. 10, no. 168 (E-411)[2224], 14 juin 1986; & JP-A-61 19 176
- PATENT ABSTRACTS OF JAPAN, vol. 10, no. 209 (E-421)[2265], 22 juillet 1986; & JP-A-61 50 370
- Integrated Circuits Materials Devices and Fabrication, W.C. Till et al., Prentice Hall, 1982

## Description

La présente invention a pour objet un procédé de fabrication d'une cellule de mémoire intégrée. Elle s'applique en particulier dans le domaine de la fabrication d'un circuit intégré à technologie MOS comportant des mémoires, et notamment des mémoires non volatiles du type EPROM, c'est-à-dire des mémoires programmables électriquement et effaçables par exposition sous rayonnement ultraviolet, ou du type EEPROM, c'est-à-dire des mémoires programmables et effaçables électriquement.

Une mémoire intégrée est un circuit intégré comprenant une partie mémoire proprement dite appelée cellule mémoire formée de plusieurs points mémoires connectés électriquement entre eux, et de circuits périphériques servant à commander les points mémoires.

L'invention a pour objet uniquement la fabrication de la partie mémoire proprement dite.

Les cellules mémoires les plus modernes permettant la mémorisation de 10⁶ éléments binaires, présentent des surfaces de 20 à 25 »m² dans une technologie de 1,2 »m, c'est-à-dire dans laquelle les bandes et les espaces les plus petits mesurent 1,2 »m. La surface d'une mémoire est donc d'environ 14 à 17 fois celle du carré élémentaire de la lithographie (1200 x 1200 nm²).

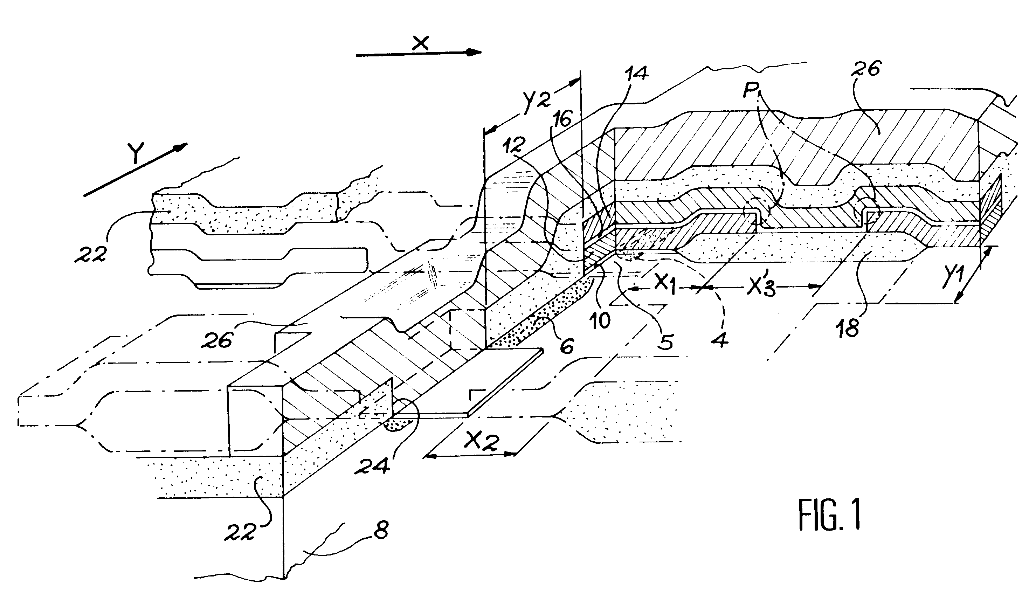

Sur la figure 1, on a représenté schématiquement en perspective une cellule mémoire connue du type EPROM, c'est-à-dire une cellule de mémoire électriquement programmable à la lecture seulement et effaçable par un rayonnement ultraviolet.

Comme représenté sur la figure 1, un point mémoire est formé d'un transistor comprenant une source 4, un canal 5 et un drain 6 réalisés dans un substrat 8 semi-conducteur monocristallin en silicium ; la source et le drain présentent des conductivités inverses de celles du substrat.

Le transistor comprend en outre un isolant de grille 10 généralement un oxyde de silicium, sur lequel sont empilées une première grille 12 et une seconde grille 14 généralement réalisées en silicium polycristallin dopé au phosphore. Ces deux grilles sont séparées par une fine couche d'isolant 16 généralement en oxyde de silicium.

La première grille 12 est une grille flottante et la seconde grille 14 est la grille de commande du point mémoire.

Le point mémoire est isolé électriquement au moyen d'un oxyde de champ 18 réalisé par exemple par oxydation localisée et superficielle du substrat à travers un masque de nitrure de silicium, des autres points mémoires ainsi que des circuits périphériques de commande de ce point.

L'ensemble d'une cellule mémoire est recouverte d'une couche épaisse isolante 22 généralement en oxyde de silicium dans laquelle sont réalisés les trous de contact électriques des sources et des drains tels que 24. Les connexions électriques entre les sources et les drains des différents points mémoires et/ou les différents circuits périphériques de commande sont assurées par une couche conductrice 26, généralement en aluminium, déposée sur la couche isolante 22 et gravée de façon appropriée.

Les connexions électriques entre les grilles de commande des différents points mémoires sont définies en même temps que les grilles de commande 14 et dans la même couche de silicium polycristallin.

La demanderesse a été confrontée à plusieurs problèmes techniques dans la réalisation de ces cellules mémoires.

Le premier problème est celui de la densité d'intégration.

En effet, de plus en plus, on cherche à diminuer la dimension des circuits intégrés et en particulier des mémoires en vue d'augmenter leur densité d'intégration. Il est rappelé que jusqu'à présent, on s'est intéressé uniquement, dans les mémoires actuellement connues, à deux facteurs de limitation de la réduction des dimensions de la cellule mémoire.

Le premier facteur est le recouvrement entre la grille flottante 12 et l'oxyde de champ 18 ; un débordement X1 de la grille flottante 12 au-dessus de l'oxyde de champ 18 et un débordement Y1 de l'oxyde de champ 18 par rapport à la grille flottante 12 sont nécessaires à cause de l'imprécision de superposition des différentes couches constituant les points mémoires et des masques de lithographie, nécessaires pour la gravure des différentes couches. Ces débordements sont respectivement dans la direction X des lignes de mots (ou connexions de grilles) de la cellule mémoire et dans la direction Y des canaux des points mémoires, qui est perpendiculaire à la direction X.

Le second facteur est la nécessité de prévoir des gardes isolantes autour des trous de contact de la ligne d'éléments binaires, c'est-à-dire autour des trous de contact des drains des points mémoires. Une garde isolante X2 est prévue dans la direction X entre le contact de drain et l'oxyde de champ 18, et une autre garde isolante Y2 est prévue dans la direction Y entre le contact de drain et les grilles 12 et 14.

La diminution des dimensions lithographiques ne s'accompagnant pas généralement d'une amélioration proportionnelle dans les précisions de superpositions de différents niveaux, notamment de masques lithographiques, les facteurs de limitation mentionnés ci-dessus sont de plus en plus pénalisant pour l'augmentation de la densité d'intégration des mémoires.

On recherche par conséquent à améliorer les procédés de fabrication des cellules mémoires de manière à obtenir un autoalignement ou un autopositionnement pour éviter le recouvrement entre la grille flottante et l'oxyde de champ et/ou les gardes isolantes autour des trous de contact.

Le deuxième problème réside dans le fait que les cellules mémoires fabriquées par les procédés classiques présentent des points faibles repérés par la référence P sur la figure 1. Ces points sont localisés au niveau des angles formés par les bords extrêmes des grilles et le diélectrique interpoly 16.

Le troisième problème réside dans le fait que les cellules mémoires réalisées par le procédé classiques ont une structure qui présente un relief important alors qu'il serait préférable d'obtenir une structure qui se rapproche d'une structure plane.

La présente invention a pour objet un procédé de fabrication d'une cellule mémoire qui permet de résoudre l'ensemble de ces problèmes et en particulier d'augmenter la densité d'intégration des mémoires grâce à une diminution de leur taille, et cela d'une manière inattendue en diminuant l'écart X′3 entre deux grilles flottantes de deux points mémoires, cet écart étant celui qui est pris selon la direction d'une ligne de mots que l'on qualifie également de ligne de commande.

La présente invention a donc pour objet un procédé de fabrication d'une cellule mémoire intégrée sur un substrat semi-conducteur comportant une matrice de points mémoires isolés électriquement les uns des autres, chaque point mémoire comprenant un drain, une source, une grille flottante, les grilles flottantes de chaque point mémoire étant distantes et isolées latéralement suivant une première direction d'une ou de deux autres grilles flottantes ; le procédé étant principalement caractérisé en ce qu'il comporte une étape de réalisation des isolations latérales des grilles flottantes suivant la première direction, puis une étape de réalisation des grilles flottantes proprement dites.

Le procédé selon la revendication 1 de la présente invention consiste à utiliser un masque de gravure comportant des motifs définissant la longueur des grilles flottantes, dans lequel le masque de gravure utilisé comporte un motif de grille sur deux, le motif du masque ayant un pas qui correspond à deux longueurs L' de grilles flottantes augmenté de deux longueurs X3 d'espaces séparant deux grilles flottantes. La réalisation des isolations des grilles flottantes comporte une étape de dépôt d'une couche sacrificielle puis une gravure de cette couche au moyen du masque présentant un motif de grille sur deux, puis un dépot d'une couche d'isolant puis une gravure de l'isolant pour réaliser des espaceurs de largeur X3 submicroniques désirée et enfin une élimination de la couche sacrificielle.

Avantageusement, le procédé comporte les étapes suivantes :
a) au préalable :
   - formation dans le substrat des zones actives séparées par de l'oxyde épais formant l'oxyde de champ isolant les points mémoires,
   - formation d'une couche de matériau servant de protection du substrat,
   - dopage des régions de canal par implantation ionique à travers la couche de protection,
b) puis réalisation des isolations latérales par :
   - dépôt de la couche sacrificielle,
   - gravure de cette couche pour obtenir les motifs désirés,
   - dépôt de la couche mince d'isolant,
   - gravure de l'isolant de manière à réaliser les espaceurs contre les bords latéraux des motifs de la couche sacrificielle gravée,
   - élimination des motifs de la couche sacrificielle,
   - élimination de la couche de protection,
   - formation d'une couche mince de matériau isolant pour former un isolant de grille,
c) réalisation des grilles flottantes par dépôt et gravure,
d) réalisation des grilles de commande par dépôt, masquage et gravure,
e) réalisation des sources et des drains,
f) réalisation des contacts,
g) réalisation des interconnexions.

Avantageusement, la réalisation des grilles flottantes effectuée durant l'étape c) comporte les sous-étapes successives suivantes :
- dépôt d'une première couche de silicium polycristallin,
- dépôt d'une couche de résine de planarisation,
- gravure à vitesse identique de la résine et du silicium polycristallin permettant de mettre à nu le silicium polycristallin,
- dopage de la première couche de silicium polycristallin.

Selon un mode préféré de réalisation, la couche sacrificielle est une couche de silicium polycristallin.

Selon un mode préféré de réalisation, le substrat est en silicium et la couche mince de matériau isolant est une couche d'oxyde de silicium obtenue par oxydation du silicium formant le substrat.

Avantageusement, la couche de protection est constituée par le masque de nitrure ayant servi à réaliser l'oxyde de champ.

Selon un mode de réalisation, la résine de planarisation est déposée par centrifugation.

Selon un mode de réalisation, la réalisation des grilles flottantes comporte une dernière étape consistant à effectuer une élimination des résidus éventuels de résine au moyen d'un plasma d'oxygène.

Selon une variante de réalisation, le dopage de la couche de silicium polycristallin est effectué juste après le dépôt de cette couche de silicium polycristallin.

Avantageusement la réalisation des grilles de commande effectuée durant l'étape d) comporte les sous-étapes successives suivantes :
- réalisation de la couche d'isolant inter-grille ;
- dépôt d'une deuxième couche de silicium polycristallin ;
- dopage de la deuxième couche de silicium polycristallin ;
- gravure de cette deuxième couche à partir d'un masque ayant des motifs définissant les grilles de commande ;
- gravure partielle de la couche d'isolant formant les espaceurs et de la couche d'isolant intergrille dans les zones où ces couches ne sont pas recouvertes par la deuxième couche de silicium polycristallin ;
- gravure sélective de la première couche de silicium polycristallin par rapport à la couche d'isolant, dans les zones non recouvertes par la deuxième couche de silicium polycristallin.

D'autres caractéristiques et avantages de l'invention ressortiront mieux de la description qui va suivre, donnée à titre illustratif et non limitatif. La description se réfère aux figures annexées dans lesquelles :
- la figure 1, déjà décrite, représente schématiquement en perspective une cellule mémoire EPROM conformément à l'art antérieur ;
- la figure 2 représente schématiquement en perspective une cellule mémoire EPROM conformément à l'invention ;
- les figures 3 à 10 représentent des étapes intermédiaires successives du procédé de fabrication selon l'invention ;
- la figure 11, représente de façon très simplifié le schéma d'un masque de gravure pour la réalisation des grilles flottantes selon l'art antérieur ;
- la figure 12, représente de façon très simplifié le masque de gravure utilisé dans le cadre du procédé selon l'invention pour réaliser les espaceurs submicroniques.

La description ci-après se réfère à une cellule mémoire EPROM. Bien entendu, le procédé selon l'invention s'applique également aux cellules mémoires EEPROM. En vue d'une simplification on ne décrira qu'une cellule mémoire EPROM formée de points mémoires à canal N réalisée sur un substrat en silicium monocristallin de type p, l'invention ayant une portée beaucoup plus générale puisqu'elle s'applique à tout type de mémoire à grille flottante réalisée sur un substrat semi-conducteur quelconque.

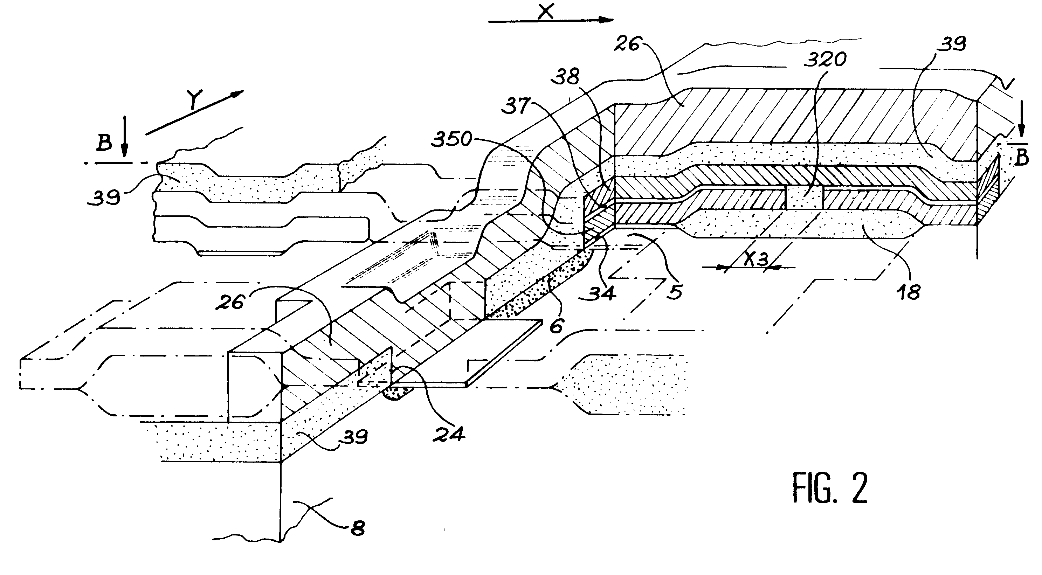

La cellule mémoire EPROM représentée sur la figure 2 comporte, comme les cellules mémoires de l'art antérieur, une matrice de points mémoires formée de transistors comportant chacun une source 4, un drain 6 de type n+ réalisé sur un substrat 8 en silicium monocristallin de type p, des empilements de matériau sont prévus entre la source et le drain. Ces empilements sont formés, en partant du substrat 8, d'un premier isolant 34 en oxyde de silicium, d'une grille flottante 350 en silicium polycristallin dopé au phosphore, d'un second isolant 37 formé de trois matériaux isolants empilés SiO₂, Si₃N₄ et SiO₂ et d'une grille de commande 38 en silicium polycristallin dopé au phosphore. Ces empilements sont typiquement compris entre 600 à 700 nanomètres.

Afin d'isoler électriquement les uns des autres les points mémoires, des isolations latérales 18 sont prévues. Ces isolations s'accompagnent d'un dopage de type p+ du substrat.

Les grilles flottantes de chaque point mémoire sont distantes les unes des autres suivant la direction X. Cette distance est repérée par la référence X3.

Conformément au procédé de fabrication objet de l'invention, la distance X3 est réduite par rapport à l'art antérieur. L'isolation latérale des grilles suivant cette direction X est réalisée conformément à l'invention avant la réalisation des grilles flottantes proprement dites.

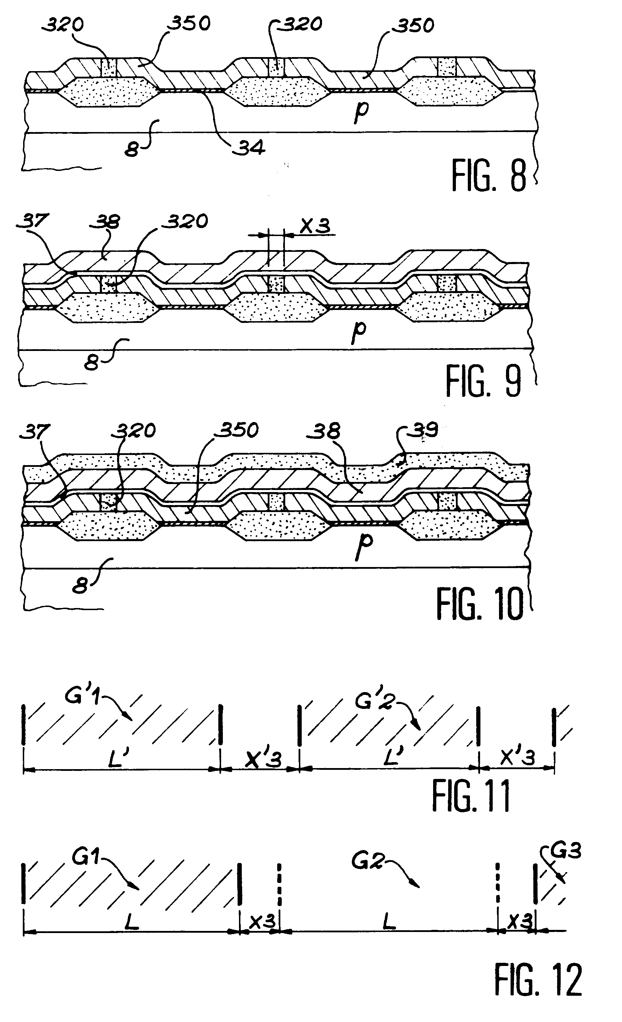

Pour réaliser les grilles flottantes, on utilise généralement un masque de gravure lithographique ayant des motifs d'un pas donné correspondant à la longueur d'une grille à laquelle se rajoute la distance X′3 (figure 11). En réalisant conformément à l'invention les isolations des grilles flottantes avant la réalisation des grilles proprement dites, on utilise un masque de gravure ayant des motifs d'un pas supérieur à celui qui est utilisé pour réaliser les grilles flottantes suivant l'art antérieur. On a représenté de façon très schématique sur la figure 11 les motifs de grilles G′1, G′2, du masque de gravure selon l'art antérieur. On a représenté sur la figure 12 les motifs du masque de gravure permettant de réaliser les isolations latérales des grilles flottantes. Ces motifs présentent un pas correspondant à la longueur L d'une grille G1 et à la longueur L d'une deuxième grille G2 augmentée de deux espaces de longueur X3 séparant respectivement les grilles G1 et G2 et la grille G2 d'une grille G3.

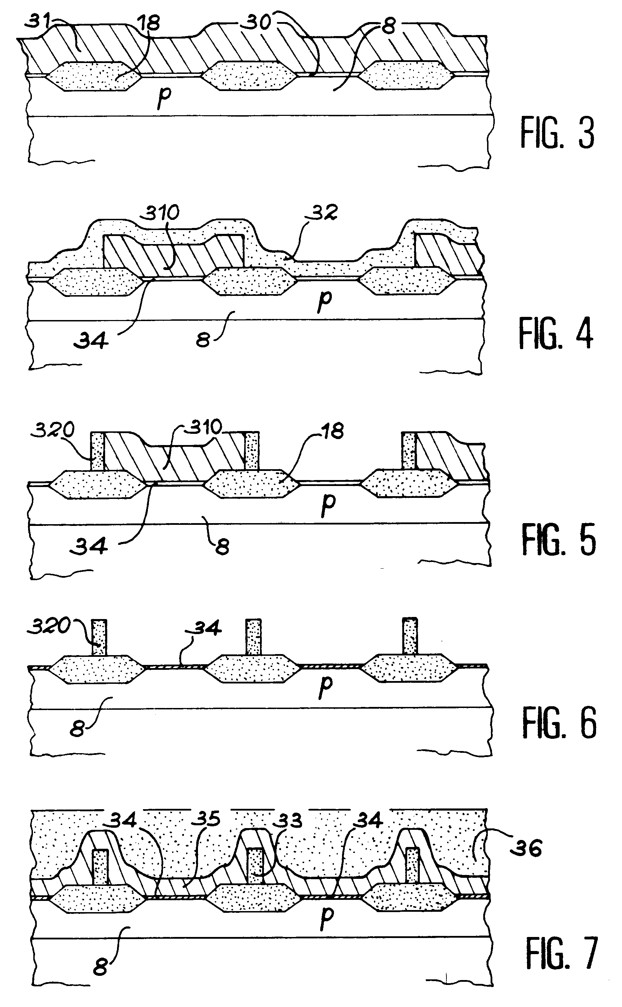

L'ensemble des différentes étapes de fabrication d'une cellule de mémoire intégrée selon l'invention sont décrites en référence aux figures 3 à 10 qui sont des vues en coupe suivant l'axe BB.

La réalisation des isolations des grilles flottantes comporte une étape de dépôt d'une couche sacrificielle 31 qui est avantageusement une couche de silicium polycristallin, puis une étape de gravure de cette couche au moyen du masque qui vient d'être défini, puis une étape de dépôt d'une couche 32 d'isolant au-dessus de cette couche gravée de silicium polycristallin 31 et enfin une étape de gravure de l'isolant 32 et du silicium polycristallin 31 afin de réaliser des espaceurs 320 de largeur désirée, c'est-à-dire X3. Ces espaceurs 320 sont formées à partir de la couche d'isolant 32, qui s'est déposée contre les flancs latéraux des motifs 310 de la couche de silicium polycristallin 31.

La couche sacrificielle 31 est une couche qui est déposée sur un substrat gravé sélectivement et anisotropiquement par rapport à ce substrat qui reçoit une nouvelle couche pouvant elle-même être gravée et qui est ensuite complètement éliminée.

On choisit pour cette couche un matériau qui permet de réaliser toutes les opérations de dépôt et de gravure citées ci-dessus.

C'est pourquoi, à titre d'exemple non limitatif, cette couche a été réalisée en silicium polycristallin.

Le procédé de fabrication d'une cellule mémoire intégrée selon l'invention comporte donc les étapes suivantes :
a) au préalable :
   - on part d'un substrat par exemple en silicium monocristallin 8 de type p, on forme dans ce substrat des zones actives séparées par de l'oxyde épais formant l'oxyde de champ 18 qui sert à isoler les points mémoires. L'oxyde de champ est réalisé par oxydation localisée du substrat à travers un masque de nitrure de silicium.

   On forme une couche de matériau 30 servant à protéger le substrat jusqu'à l'étape d'oxydation de grille (par exemple une couche d'oxyde de silicium SiO₂) ou bien on utilise le masque de nitrure de silicium. On effectue un dopage dans les régions de canal par implantation ionique.
b) on réalise ensuite les isolations latérales :
   - pour cela on dépose la couche sacrificielle 31 de silicium polycristallin d'une épaisseur de 500 nm, on grave cette couche à partir du masque prédéfini et décrit en référence à la figure 11, de manière à obtenir des motifs 310 tels que représentés sur la figure 4.

On dépose ensuite la couche d'isolant 32 formée par exemple d'oxyde de silicium SiO₂ de 300 nanomètres par la technique de dépôt chimique en phase vapeur CVD.

On effectue une gravure pleine plaque (c'est-à-dire sans masque) de cette couche d'isolant 32 pour former des espaceurs 320 tels que représentés sur la figure 5. Cette gravure s'effectue avec un plasma de trifluorométhane CHF₃ sur toute l'épaisseur de la couche. Ceci permet de ne laisser de l'oxyde de silicium que sur les flancs des motifs 310 de la couche sacrificielle de silicim polycristallin.

On effectue une élimination des motifs 310 de silicium polycristallin par une gravure plasma en utilisant comme agent d'attaque de l'hexafluorure de soufre (SF₆). On obtient ainsi les espaceurs 320 de largeur X3 tels que représentés sur la figure 6.

On effectue ensuite une élimination de la couche de protection 30 à l'aide d'acide fluorhydrique dilué. On réalise de façon classique l'oxyde de grille 34 par oxydation thermique.

On procède ensuite à un dépôt d'une couche de silicium polycristallin 35 de 250 nanomètres par un procédé de dépôt chimique en phase vapeur CVD ou LPCVD. Dans cette couche 35 seront réalisées par la suite les grilles flottantes des points mémoires.

On dépose alors par une technique classique une couche de résine 36, photosensible, effaçant le relief de la couche 35. Cette couche de résine 36, dite de planarisation, présente une épaisseur d'environ 1400 nanomètres. Le dépôt de celle-ci peut être suivie d'un traitement thermique, par exemple d'un chauffage à une température de l'ordre de 250°C pendant une 1/2 heure, afin d'obtenir un bon étalement de cette couche de résine.

On effectue ensuite une gravure simultanée de la couche de résine 36 et de la couche de silicium polycristallin 35, à des vitesses d'attaque identiques pour la résine 36, pour le silicium polycristallin 35 et pour l'oxyde 320 jusqu'à mise à nu de la surface des bandes 350, telles que représentées sur la figure 8, la hauteur restante des espaceurs 320 étant alors similaire à celle des bandes 350.

Cette gravure est réalisée par exemple de façon anisotrope par un procédé de gravure ionique réactive utilisant comme agent d'attaque un mélange de tri ou tétrafluorométhane et d'oxygène, les composés fluorés servent à la gravure du silicium polycristallin et de l'oxyde et l'oxygène à la gravure de la résine.

On peut procéder ensuite à une élimination des résidus de résine éventuels avec comme agents d'attaque du H₂SO₄ et du H₂O₂.

Le dépôt de la résine 36 est par exemple réalisé par centrifugation.

Le dopage au phosphore du silicium polycristallin 350 peut être réalisé juste après le dépôt, par diffusion de POCL3.

Le dopage au phosphore du silicium polycristallin 350 peut également être réalisé après la gravure qui est effectuée à vitesse identique de la résine 36 de la couche de silicium polycristallin 35. On réalise ensuite la formation d'une couche 37 d'isolant (couche intergrille), cette couche étant par exemple de l'oxyde de silicium. On peut effectuer par exemple, aussi, une isolation du type tri-couche au moyen d'une couche d'oxyde de silicium, d'une couche de nitrure de silcium et d'une couche d'oxyde de silicium. Dans ce cas, la première couche d'oxyde aura une épaisseur de 25 nanomètres, la couche de nitrure de silicium aura une épaisseur de 15 nanomètres et la dernière couche d'oxyde aura une épaisseur de 5 nanomètres.

Sur l'isolant 37 on dépose une autre couche de silicium polycristallin 38 dopée au phosphore par diffusion de POCL3, dans laquelle seront réalisées ultérieurement les secondes grilles ou grilles de commande des points mémoires. Cette couche 38 peut être obtenue par la technique de dépôt chimique en phase vapeur CVD ou LPCVD et présente une épaisseur de 400 nanomètres. Pour obtenir ces grilles de contrôle (correspondant aux lignes de mots) on effectue une gravure de cette couche 38 à partir d'un masque ayant des motifs définissant les largeurs (selon l'axe Y) des grilles de commande.

A ce stade les largeurs des grilles flottantes ne sont pas encore définies, seules les longueurs de ces grilles flottantes sont définies. La présence des espaceurs 320 a permis d'obtenir les bandes 350 dans la direction Y.

Dans les régions non recouvertes par la couche 38 de silicium polycristallin, dans les zones qui ne sont donc pas recouvertes par les grilles de commande qui viennent d'être définies, on procède à une gravure des motifs 350 obtenus à partir de la couche 35 de silicium polycristallin de manière à définir la largeur des grilles flottantes. Pour cela on procède tout d'abord à une gravure des espaceurs 320 et de l'isolant inter-grille 37 dans ces régions non protégées par la couche 38 en silicium polycristallin. On effectue en fait, une gravure partielle de l'oxyde de silicium 320 formant les espaceurs sur une épaisseur de 200 nanomètres. Cette gravure est effectuée de façon anisotrope et sélective par rapport au silicium polycristallin à l'aide d'une gravure du type ionique réactive utilisant comme agent d'attaque du CHF₃ ou du CF₄. Puis on effectue une gravure du silicium polycristallin 350 sélectivement par rapport à l'oxyde de silicium 320. Cette gravure est effectuée de façon anisotrope à l'aide d'une gravure du type ionique réactive utilisant comme agent d'attaque de l'hexafluorure de soufre (SF₆) plus du HCL à 50%. On a procédé à une gravure partielle des espaceurs 320 afin que l'oxyde de silicium restant protège le substrat 8 lors de la gravure du silicium polycristallin 350. La couche peu épaisse d'oxyde de silicium restante ne gêne pas à l'implantation ionique.

On effectue ensuite, de façon classique, un dopage des sources et des drains, puis un dépôt d'isolant 39 recouvrant toute la cellule mémoire comme représenté sur la figure 10. On réalise pour finir, de façon classique, les contacts et les interconnexions entre cellules mémoires comme on peut le voir sur la figure 2.

Le procédé selon l'invention permet de réaliser des cellules mémoires ayant des écarts submicroniques entre grilles flottantes.

Il permet d'améliorer notablement la planéité de la structure en supprimant les marches que forment les grilles de commande sur les grilles flottantes.

Il permet de supprimer les points faibles P, car les angles que formaient le diélectrique interpoly et les bords des grilles flottantes n'existent plus dans cette nouvelle structure obtenue par le procédé selon l'invention.

D'autre part, pour une dimension de cellule donnée, la surface de couplage entre les grilles de commande et les grilles flottantes est augmentée par ce procédé.

## Revendications

1. Procédé de fabrication d'une cellule mémoire intégrée du type EPROM ou EEPROM sur un substrat semi-conducteur comportant une matrice de points mémoires isolés électriquement les uns des autres, chaque point mémoire comprenant une source (4), un drain (6), une grille flottante (350), une grille de commande (38), un canal (5) situé sous la grille flottante (350), la source (4) et le drain (6) étant situés de part et d'autre de la grille flottante (350), les grilles flottantes de chaque point mémoire étant distantes et isolées latéralement suivant une première direction (X), ladite direction étant perpendiculaire à la direction du canal (5), d'une ou de deux autres grilles flottantes, ledit procédé comportant une étape de réalisation des isolations latérales (320) des grilles flottantes suivant la première direction (X) par des motifs isolants en relief, puis une étape de réalisation des grilles flottantes (350) proprement dites par dépôt et gravure, et utilisant pour réaliser les isolations latérales (320) entre les grilles flottantes (350), un masque de gravure comportant des motifs définissant la longueur des grilles flottantes, caractérisé en ce que la réalisation des isolations des grilles flottantes comporte une étape de dépôt d'une couche (31) sacrificielle puis une gravure de cette couche au moyen d'un masque de gravure ayant un motif correspondant à une grille sur deux, le motif du masque ayant un pas qui correspond à deux longueurs (L) de grilles flottantes augmenté de deux longueurs (X3) d'espaces séparant deux grilles, puis un dépôt d'une couche (32) d'isolant, puis une gravure de l'isolant (32) pour réaliser les motifs isolants en relief du type espaceur (320) de largeur submicronique désirée (X3) et enfin une élimination de la couche sacrificielle (31).

2. Procédé selon la revendication 1, caractérisé en ce qu'il comporte les étapes suivantes :
a) au préalable :
- formation dans le substrat (8) des zones actives séparées par de l'oxyde épais formant l'oxyde de champ isolant les points mémoires,
- formation d'une couche de matériau (30) servant de protection du substrat,
- dopage des régions de canal par implantation ionique à travers la couche de protection (30),
b) puis réalisation des isolations latérales par :
- dépôt de la couche sacrificielle (31),
- gravure de cette couche (31) pour obtenir les motifs (310) désirés,
- dépôt de la couche mince d'isolant (32),
- gravure de l'isolant (32) de manière à réaliser les motifs isolants en relief du type espaceur (320) contre les bords latéraux des motifs (310) de la couche sacrificielle gravée,
- élimination des motifs (310) de la couche (31) sacrificielle,
- élimination de la couche (30) de protection,
- formation d'une couche (34) mince de matériau isolant pour former un isolant de grille,
c) réalisation des grilles flottantes par dépôt et gravure,
d) réalisation des grilles de commande par dépôt, masquage et gravure,
e) réalisation des sources (4) et des drains (6),
f) réalisation des contacts (24),
g) réalisation des interconnexions (26).

3. Procédé selon la revendication 2, caractérisé en ce que la réalisation des grilles flottantes comporte les étapes suivantes :
- dépôt d'une première couche (35) de silicium polycristallin,
- dépôt d'une couche de résine (36) de planarisation,
- gravure à vitesse identique de la résine (36) et du silicium polycristallin (35) permettant de mettre à nu le silicium polycristallin,
- dopage de la première couche de silicium polycristallin.

4. Procédé selon l'une quelconque des revendications 2 et 3, caractérisé en ce que la couche sacrificielle (31) est constituée de silicium polycristallin.

5. Procédé selon l'une quelconque des revendications 2 à 4, caractérisé en ce que le substrat est en silicium et en ce que la couche mince de matériau isolant (34) est un oxyde de silicium réalisé par oxydation du substrat.

6. Procédé selon l'une quelconque des revendications 2 à 5, caractérisé en ce que la couche de protection (30) est constituée par le masque de nitrure ayant servi à réaliser l'oxyde de champ.

7. Procédé selon la revendication 3, caractérisé en ce que le dopage de la première couche de silicium polycristallin (35) est effectué juste après le dépôt de cette couche (35).

8. Procédé selon l'une quelconque des revendications 1 à 7, caractérisé en ce que la réalisation des grilles de commande comporte les étapes successives suivantes :
- dépôt de la couche (37) d'isolant inter-grille ;
- dépôt d'une deuxième couche (38) de silicium polycristallin ;
- dopage de la deuxième couche (38) de silicium polycristallin ;
- gravure de cette deuxième couche (38) à partir d'un masque ayant des motifs définissant les grilles de commande (38) ;
- gravure partielle de la couche d'isolant formant les espaceurs (320) ainsi que de la couche (37) d'isolant inter-grille dans les zones où ces couches ne sont pas recouvertes par la deuxième couche (38) de silicium polycristallin ;
- gravure sélective de la première couche (35) de silicium polycristallin par rapport à l'isolant (320), dans les zones non recouvertes par la deuxième couche de silicium polycristallin (38).

## Claims

1. Process for the production of an EPROM or EEPROM-type integrated memory cell on a semiconductor substrate having a matrix of memory points which are electrically insulated from one another, each memory point comprising a source (4), a drain (6), a floating gate (350), a control gate (38), a channel (5) located below the floating gate (350), the source (4) and the drain (6) being located on either side of the floating gate (350), the floating gates of each memory point being separate and laterally insulated in a first direction (X), said direction being perpendicular to the direction of the channel (5), with respect to one or two other floating gates, said process having a stage of producing lateral insulations (320) of the floating gates in the first direction (X) by insulating relief patterns, followed by a stage of actually producing the floating gates (350) by deposition and etching, and using for the formation of the lateral insulations (320) between the floating gates (350), an etching mask having patterns defining the length of the floating gates, characterized in that the formation of the insulations of the floating gates involves a stage of depositing a sacrificial layer (31) and then etching said layer by means of an etching mask having a pattern corresponding to one out of every two gates, the pattern of the mask having a spacing corresponding to two lengths (L) of floating gates increased by two lengths (X3) of spaces separating two gates, followed by a deposition of an insulating layer (32), followed by the etching of the insulant (32) in order to produce insulating relief patterns of the spacer type (320) and having the desired submicron width (X3) and finally eliminating the sacrificial layer (31).

2. Process according to claim 1, characterized in that it has the following stages:
a) beforehand:
formation in the substrate (8) of active zones separated by the thick oxide forming the field oxide insulating the memory points,
formation of a material layer (30) for protecting the substrate,
doping the channel regions by ion implantation through the protection layer (30),
b) then producing the lateral insulations by:
deposition of the sacrificial layer (31),
etching said layer (31) to obtain the desired patterns (310),
deposition of the thin insulating layer (32),
etching the insulant (32) so as to produce insulating relief patterns of the spacer type (32) against the lateral edges of the patterns (310) of the etched sacrificial layer,
elimination of the patterns (310) of the sacrificial layer (31),
elimination of the protection layer (30),
formation of a thin insulating material layer (34) in order to form a gate insulant,
c) producing floating gates by deposition and etching,
d) producing control gates by deposition, masking and etching,
e) producing sources (4) and drains (6),
f) producing contacts (24),
g) producing interconnections (26).

3. Process according to claim 2, characterized in that the formation of the floating gates involves the following stages:
deposition of a first polycrystalline silicon layer (35),
deposition of a planarization resin layer (36),
etching at an identical speed the resin (36) and the polycrystalline silicon (35), so as to expose the polycrystalline silicon,
doping the first polycrystalline silicon layer.

4. Process according to either of the claims 2 and 3, characterized in that the sacrificial layer (31) is constituted by polycrystalline silicon.

5. Process according to any one of the claims 2 to 4, characterized in that the substrate is of silicon and in that the thin insulating material layer (34) is a silicon oxide produced by oxidizing the substrate.

6. Process according to any one of the claims 2 to 5, characterized in that the protection layer (30) is constituted by the nitride mask used for producing the field oxide.

7. Process according to claim 3, characterized in that the first polycrystalline silicon layer (35) is doped just after the deposition of said layer (35).

8. Process according to any one of the claims 1 to 7, characterized in that the formation of the control gates involves the following successive stages:
deposition of the inter-gate insulating layer (37),
deposition of a second polycrystalline silicon layer (38),
doping the second polycrystalline silicon layer (38),
etching said second layer (38) from a mask having patterns defining the control gates (38),
partial etching of the insulating layer forming spacers (320), as well as the inter-gate insulating layer (37) in the areas where said layers are not covered by the second polycrystalline silicon layer (30),
selective etching of the first polycrystalline silicon layer (35) relative to the insulant (320), in the the areas not covered by the second polycrystalline silicon layer (38).

## Patentansprüche

1. Herstellungsverfahren einer integrierten Speicherzelle des Typs EPROM oder EEPROM auf einem Halbleitersubstrat, eine Matrix aus Speicherpunkten umfassend, die elektrisch voneinander isoliert sind, wobei jeder Speicherpunkt eine Source (4), einen Drain (6), ein floatendes Gate (350), ein Steuergate (38) und einen unter dem floatenden Gate (350) befindlichen Kanal (5) umfaßt, wobei die Source (4) und der Drain (6) sich beiderseits des floatenden Gates (350) befinden, die floatenden Gates jedes Speicherpunkts beabstandet und seitlich isoliert sind in einer ersten Richtung (X) von einem oder zwei anderen Gates, wobei die genannte Richtung senkrecht ist zu der Richtung des Kanals (5), wobei das genannte Verfahren einen Herstellungsschritt der seitlichen Isolationen (320) der floatenden Gates in der ersten Richtung (X) durch hervorstehende isolierende Muster umfaßt, dann einen Herstellungsschritt der eigentlichen floatenden Gates (350) mittels Abscheidung und Ätzung und unter Verwendung, um die seitlichen Isolationen (320) zwischen den floatenden Gates (350) zu erzeugen, einer Ätzmaske, die Muster enthält, die die Länge der floatenden Gates definieren,
**dadurch gekennzeichnet**
daß die Erzeugung der Isolationen der floatenden Gates einen Schritt der Abscheidung einer Opferschicht (31) umfaßt, sodann eine Ätzung dieser Schicht mittels einer Ätzmaske, die ein jedem zweiten Gate entsprechendes Muster aufweist, wobei das Muster der Maske eine Teilung besitzt, die zwei Floating-Gate-Längen (L) entspricht, erhöht um zwei Längen (X3) der Zwischenräume, die zwei Gates trennen, dann eine Abscheidung einer Isolationsschicht (32), dann eine Ätzung der Isolation (32), um die hervorstehenden isolierenden Muster des Typs Spacer (320) der gewünschten submikrometrischen Breite (X3) zu erzeugen, und schließlich eine Beseitigung der Opferschicht 31.

2. Verfahren nach Anspruch 1, dadurch gekennzeichnet, daß es die folgenden Schritte umfaßt:
a) vorhergehend:
- Bildung von aktiven Zonen in dem Substrat (8), getrennt durch dickes Oxid, das das Feldoxid bildet, das die Speicherpunkte isoliert,
- Bildung einer Materialschicht (30), die dem Schutz des Substrats dient,
- Dotierung der Kanalbereiche durch Ionenimplantation durch die Schutzschicht (30),
b) dann Erzeugung der seitlichen Isolationen durch:
- Abscheidung der Opferschicht (31),
- Ätzung dieser Schicht (31), um die gewünschten Muster (310) zu erhalten,
- Abscheidung der dünnen Isolationsschicht (32),
- Ätzung der Isolation (32), um die hervorstehenden isolierenden Muster des Typs Spacer (320) zu erzeugen an den seitlichen Rändern der Muster (310) der geätzten Opferschicht,
- Beseitigung der Muster (310) der Opferschicht (31),
- Beseitigung der Schutzschicht (30),
- Bildung einer dünnen Schicht (34) aus isolierendem Material, um einen Gateisolator zu bilden,
c) Erzeugung der floatenden Gates durch Abscheidung und Ätzung,
d) Erzeugung der Steuergates durch Abscheidung, Maskierung und Ätzung
e) Erzeugung der Sources (4) und der Drains (6),
f) Erzeugung der Kontakte (24),
g) Erzeugung der Zwischenverbindungen (26).

3. Verfahren nach Anspruch 2, dadurch gekennzeichnet, daß die Erzeugung der floatenden Gates die folgenden Schritte umfaßt:
- Abscheidung einer ersten Schicht (35) aus polykristallinem Silicium,
- Abscheidung einer Planarisierungs-Harzschicht (36),
- Ätzung des Harzes (36) und des polykristallinen Siliciums (35) mit gleicher Geschwindigkeit, was das polykristalline Silicium freilegt,
- Dotierung der ersten Schicht aus polykristallinem Silicium.

4. Verfahren nach einem der Ansprüche 2 und 3, dadurch gekennzeichnet, daß die Opferschicht (31) durch polykristalines Silicium gebildet wird.

5. Verfahren nach einem der Ansprüche 2 bis 4, dadurch gekennzeichnet, daß das Substrat aus Silicium ist und dadurch, daß die dünne Schicht aus isolierendem Material (34) ein Siliciumoxid ist, erzeugt durch Oxidation des Substrats.

6. Verfahren nach einem der Ansprüche 2 bis 5, dadurch gekennzeichnet, daß die Schutzschicht (30) gebildet wird durch die Nitridmaske, die dazu gedient hat, das Feldoxid zu erzeugen.

7. Verfahren nach Anspruch 3, dadurch gekennzeichnet, daß die Dotierung der ersten Schicht aus polykristallinem Silicium (35) unmittelbar nach der Abscheidung dieser Schicht (35) durchgeführt wird.

8. Verfahren nach einem der Ansprüche 1 bis 7, dadurch gekennzeichnet, daß die Erzeugung der Steuergates die folgenden aufeinanderfolgenden Schritte umfaßt:
- Abscheidung der Zwischengate-Isolationsschicht (37);
- Abscheidung einer zweiten Schicht (38) aus polykristallinem Silicium;
- Dotierung der zweiten Schicht (38) aus polykristallinem Silicium;
- Ätzung dieser zweiten Schicht (38) mittels einer Maske, die Muster aufweist, die die Steuergates (38) definieren;
- Partielle Ätzung der die Spacer (320) bildenden Isolationsschicht sowie der Zwischengate-Isolationsschicht (37) in den Zonen wo die Schichten nicht bedeckt sind durch die zweite Schicht (38) aus polykristallinem Silicium;
- Selektive Ätzung der ersten Schicht (35) bezüglich des Isolators (320) in den Zonen, die nicht bedeckt sind durch die zweite Schicht (38) aus polykristallinem Silicium.
